# EUROPEAN PATENT SPECIFICATION

(11) **EP 1 465 246 B1**
(45) Date of publication and mention of the grant of the patent: **18.12.2013**
(21) Application number: 04447086.2
(22) Date of filing: 02.04.2004
(51) Int. Cl.: H01L 21/768, H01L 23/48

(54) **Method for producing electrical through hole interconnects**
Methode zur Herstellung von elektrisch leitenden Durchführungen
Procédé de fabrication d'un trou traversant électriquement conducteur

(30) Priority: 03.04.2003 EP 03447079; 03.04.2003 US 460853 P; 22.09.2003 EP 03447236; 26.09.2003 US 506560 P
(43) Date of publication of application: 06.10.2004
(73) Proprietor: IMEC, 3001 Leuven (BE)
(72) Inventor: Beyne, Eric, 3001 Leuven (BE); Labie, Riet, 3010 Kessel-Lo (BE)
(74) Representative: Van Malderen, Joëlle

(56) References cited:
- EP-A- 1 199 744
- US-A1- 2001 001 292
- US-A1- 2002 027 293

## Description

### Field of the invention

The present invention is related to the field of electrical interconnection technologies for microelectronics system elements. In particular the present invention is related to methods for producing electrical through hole interconnects.

### State of the art

The evolution of VLSI technology asks for an increasing bandwidth of interconnects between IC's and/or other system elements. For short interconnects electrical signal lines maintain the highest capacity and speed. In order to keep up with the increasing speed and density requirements, system in a package (SIP) technology is increasingly used. This creates the need for 3-dimensional interconnects.

An example of the fabrication of such interconnects can be found in patent US-B-6184060. Vias or through holes are made in the front side of the wafer, and dielectric and contact pad metal are deposited into the vias. Then the wafer back side is etched until the back metal is exposed. This method requires the back side etching up until the contact pad, including etching the dielectric deposited on the bottom of the vias. The patent indicates Silicon oxide or BPSG as material for the dielectric, deposited by CVD (Chemical Vapour Deposition). Also thermal oxidation is mentioned. Etching Silicon oxide with respect to silicon is not trivial and cannot be done anisotropically. Silicon oxide deposition produces layers with essentially uniform thickness, which limits design freedom.

Document US2002/0027293 is related to a semiconductor device having a piercing hole through a semiconductor substrate, an insulating film formed on the first surface of the substrate and an electrode formed in the piercing hole and extending from the insulating film to the second surface of the substrate. An insulating film sleeve lies between the piercing electrode and an inside wall of the piercing hole in the semiconductor substrate. The electrode is formed by electroplating followed by CMP (Chemical Mechanical Polishing).

### Aims of the invention

The present invention aims to provide a novel method for producing via or through hole interconnects between microelectronic elements, which is relatively easy to perform and can be applied relatively cheaply compared to the state of the art. The method should for instance be applicable in thin chip technology as MCM (Multi Chip Module) and system in a package (SIP) technology.

### Summary of the invention

In a first aspect the invention relates to a method according to claim 1 for the production of isolated through hole connects in a substrate comprising the steps of:
A) providing a substrate,
B) dry etching said substrate, forming at least one substrate hole,
C) depositing a layer of conducting material on the bottom and on the sidewalls of said substrate hole and possibly on top of the rest of said substrate's surface, thereby transforming said substrate hole into a conductor hole,
D) depositing a positive working photo resist,
E) opening said photo resist at the bottom of said conductor hole,
F) bottom-up electroplating a Cu-post,
G) stripping said photo-resist,
H) stripping said layer of conducting material,
I) depositing a layer of planarising dielectric material, filling the gap between said conductor hole and said Cu-post,
K) depositing and patterning a metal interconnect pattern,
L) depositing a second layer of a second dielectric material,
M) Mechanical back grinding said substrate, such that said substrate is 10 to 50 micrometer thicker than the actual Cu-post,
N) Plasma etching said substrate on the backside, stopping on said Cu-post,
O) Solder ball attachment to said Cu-post.

Advantageously the positive working photo resist is applied by spray-coating or electrophoretic deposition. Possibly the opening of said photo resist is done by UV illumination through a mask.

In a preferred embodiment the additional step is performed of patterning by dry etching said layer of planarising dielectric material, exposing said Cu-post, before applying the step of depositing and patterning a metal interconnect pattern. In an aspect the invention relates to an alternative method according to claim 4 for the production of isolated through hole connects in a substrate, comprising the steps of:
A) provide a substrate,
B) dry etching said substrate, forming at least one substrate hole,
C) depositing a layer of conducting material on the bottom and on the sidewalls of said substrate hole and possibly on top of the rest of said substrate's surface, thereby transforming said substrate hole into a conductor hole,
D) depositing a layer of planarising dielectric material, filling said conductor hole and planarising said substrate,
E) plasma etching in said layer of planarising dielectric material within said conductor hole, until the conducting material at the bottom of said conductor hole is removed, thereby transforming said conductor hole into a dielectric hole,
F) bottom-up electroplating a Cu-post,
G) stripping said layer of planarising dielectric material,
H) stripping said layer of conducting material,
J) depositing and patterning a metal interconnect pattern,
K) depositing a second layer of a second dielectric material,
L) Mechanical back grinding said substrate,
M) Plasma etching said substrate on the backside, stopping on said Cu-post,
N) Etching said layer of conductive material on the back-side of said substrate,
O) Solder ball attachment to said Cu-post.

The additional step is performed of depositing a photo-patterned dielectric layer, with contact openings on said Cu-post, before applying the step of depositing and patterning a metal interconnect pattern. In a preferred embodiment the photo-patterned dielectric layer is photo benzocyclobutene.

The substrate preferably is a silicon wafer. The substrate hole typically is circular shaped. The step of dry etching said substrate is advantageously performed by Reactive Ion Etching - Inductive Coupled Plasma (RIE-ICP). Typically the conducting material is copper. The planarising dielectric material and said second dielectric material is preferably benzocyclobutene (BCB). Preferably said second dielectric material is non-photo benzocyclobutene (BCB). In the step of plasma etching said substrate on the backside, the substrate is preferably over-etched.

### Short description of the drawings

Fig. 1 represents the steps of an embodiment for a method to create isolated through holes in a substrate.
Fig. 2 represents an alternative method to that described in Fig. 1.

### Detailed description of the invention

The embodiments and examples described below do not limit the scope of the idea and they can be slightly changed by ordinary steps known in the art in order to optimise applicability in specific practical situations. Some preferred practical embodiments are described below. For the purpose of this invention, the terms 'next layer of dielectric/conducting material' and 'previous layer of dielectric/conducting material' should be understood as the next or previous layer of dielectric/conducting material, respectively, with respect to the moment of deposition. Furthermore the term 'patternable' means that the layer can be patterned. Typically this must be possible at a scale smaller than the hole size. Preferably the patterning of said patternable dielectric material is performed by plasma-etching and/or lithographic techniques. The term 'dielectric hole' is used for a hole whereof the sidewalls are covered with a dielectric material, whereas a 'conductor hole' has sidewalls and bottom covered with a layer of conducting material.

The various steps of the method are numbered in capitals, starting from A). However, it is not always obligatory to perform all steps in alphabetical order, as some steps can constitute an alternative to certain steps that were previously mentioned. The numbering rather refers to that used in the figures.

Each step of the method is now described more in detail.

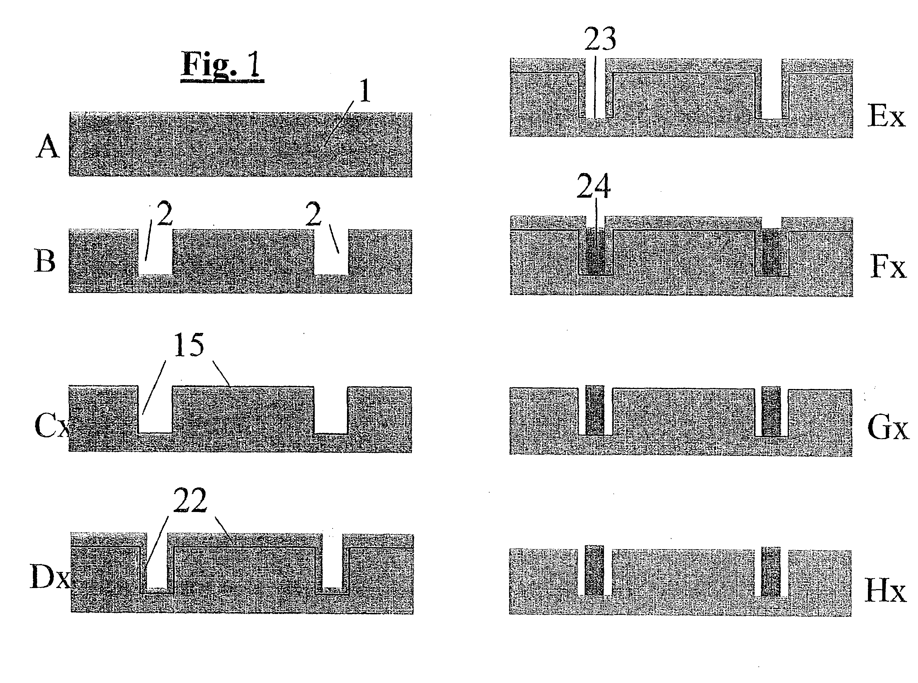

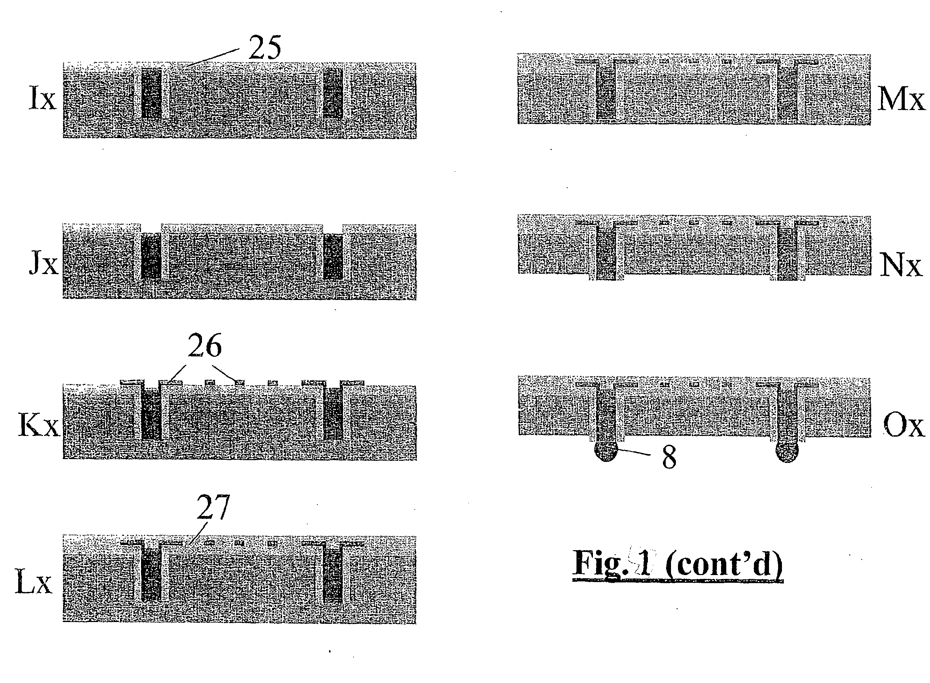

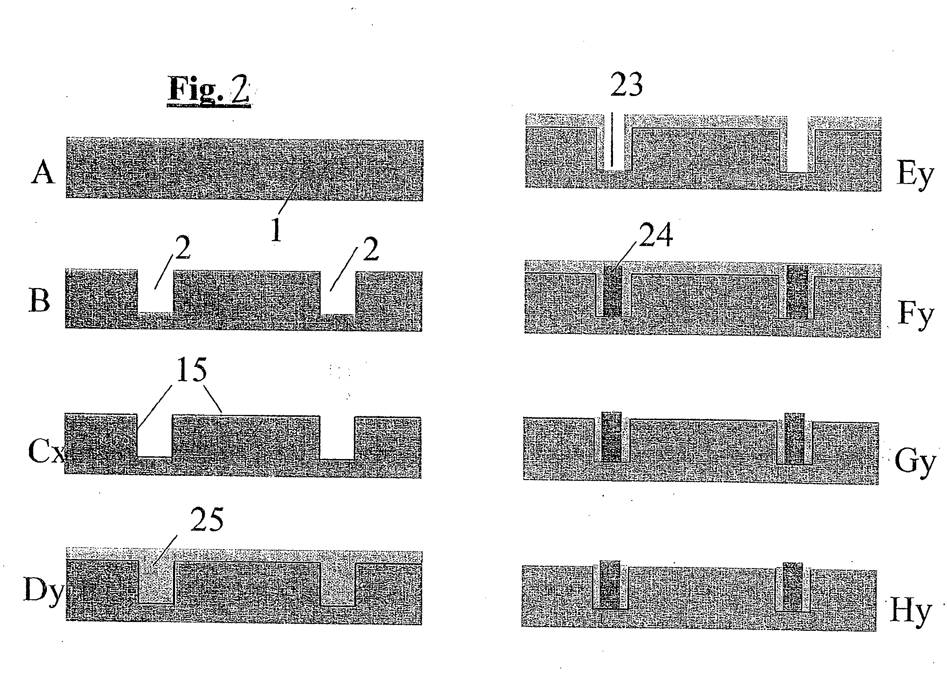

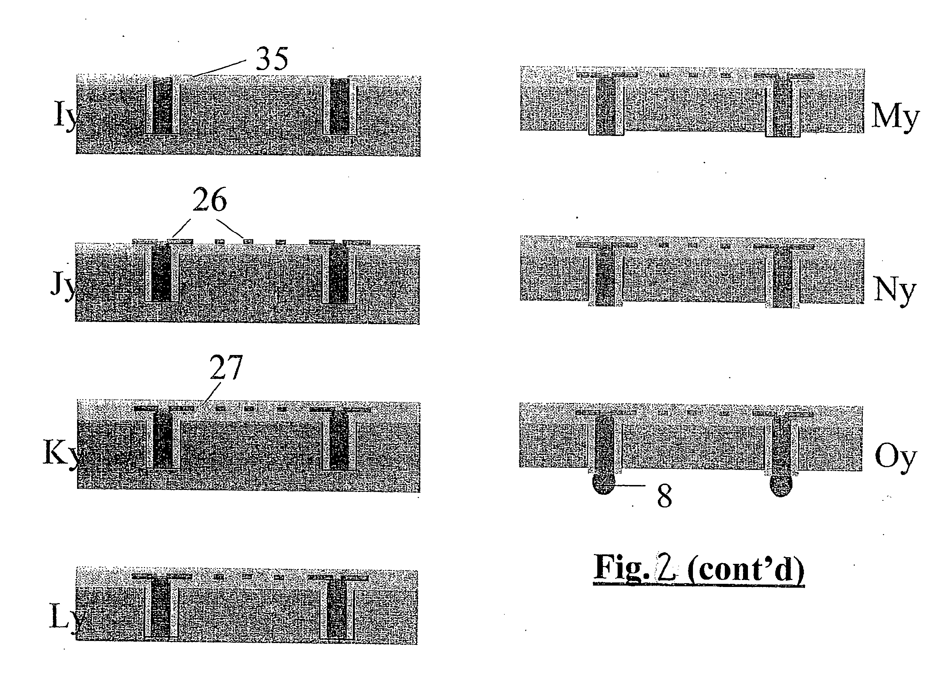

According to a first aspect the invention relates to a method for making isolated through holes or vias in a substrate. The method comprises according to a preferred embodiment the following steps (Fig.1) :
A) Providing a substrate (1), preferably a Si wafer, possibly a processed substrate (Fig.1A)
B) dry etching said substrate, typically by RIE-ICP, forming at least one substrate hole (2). Advantageously the substrate hole is cylindrical, but other shapes are also possible. A typical hole will have a diameter of 20 to 100 micrometer and an aspect ratio (width to depth) of up to 1:5. (Fig.1B)
C) Depositing a layer of conducting material (15) on the sidewalls and the bottom of the substrate hole(s), thereby transforming said substrate hole (2) into a conductor hole, and on the rest of the wafer surface. The step is preferably performed by depositing a seed layer and performing electroplating of the conducting material. Typically physical vapour deposition (PVD) of e.g. 30nm Ti/400 nm Cu will be used, Cu being a preferable conducting material. Aluminium is an alternative conducting material. The thickness of the Cu on the sidewalls and bottom of the holes may be increased by using electroless Cu plating. (Fig.1Cx)
D) Depositing a positive working photo resist (22). This layer can be applied by spin-coating, but the application by spray-coating or electrophoretic deposition is to be preferred. A typical thickness of this resist is 5 to 10 micrometer. (Fig.1Dx)
E) Opening the photo resist (22) at the bottom (23) of the hole by UV illumination through a mask. (Fig.1Ex) F) Bottom-up electroplating a Cu-post (24), with a
thickness approximately equal to the depth of the Si hole. The bottom-up filling has the advantage there is no issue with entrapped cavities or electrolytes, which are present in other state of the art techniques for forming plugs. In case of a cylindrical hole, this is a Cu cylinder. (Fig.1Fx)
G) Stripping the photo-resist layer. (Fig.1Gx)
H) Stripping the seed layer (conducting material layer) by wet chemical etching. During this etch the Cu via-fill can be slightly etched-back. (Fig.1Hx)
I) Depositing a layer of planarising dielectric material (25), filling the gap between the Si substrate and the Cu post (Fig.1Ix). A preferred dielectric for this application is BCB, as it has excellent planarisation and gap fill properties. A vacuum step is required to ensure proper filling of the gaps between the Cu and the Si. For BCB this is preferably performed at 170°C as the materials exhibits its largest flow at that temperature, before it starts to cure at higher temperatures.
J) Patterning by dry etching said layer of planarising dielectric material (25), exposing the Cu-post structures (Fig.1Jx). If the layer in I is photo-defined BCB, this step is not required.
K) Depositing and patterning a metal interconnect pattern (26) (Fig.1Kx). This could e.g. be semi-additive electroplated Cu lines. Other metals and methods are however also feasible, e.g. deposition by PVD of Cu, Al, Pt,... and patterning by wet-etching or lift-off.
L) Depositing a second layer (27) of a second dielectric material as a passivation layer (Fig.1Lx). This is preferably a second BCB coating. Other materials, inorganic or organic could also be used.
M) Mechanical back grinding the wafers, such that the substrate is 10 to 50 micrometer thicker than the actual Cu via post (Fig.1Mx),
N) Plasma etching the substrate backside, stopping on the Cu/BCB plug and slightly over-etching the silicon (Fig.1Nx),
O) Solder ball (8) attachment to the Cu studs. (Fig.1Ox) An alternative method to make isolated through holes or vias in a substrate comprises the following steps (Figure 2). The first three steps are as described above.
A) providing a substrate (1), preferably a Si wafer, possibly a processed Si wafer (Fig.2A),
B) dry etching said substrate, typically by RIE-ICP, forming at least one substrate hole (2). Advantageously the substrate hole is cylindrical, but other shapes are also possible. A typical hole will have a diameter of 20 to 100 micrometer and an aspect ratio (width to depth) of up to 1:5 (Fig.2B).
C) depositing a layer of conducting material (15) on the sidewalls and the bottom of the substrate hole(s), thereby transforming said substrate hole (2) into a conductor hole, and possibly on the rest of the wafer surface. The step is preferably performed by depositing a seed layer and performing electroplating of the conducting material. Typically physical vapour deposition (PVD) of e.g. 30nm Ti/400nm Cu will be used, Cu being a preferable conducting material. The thickness of the Cu on the sidewalls and bottom of the holes may be increased by using electroless Cu plating. In order to avoid any contamination of the Si substrate from the Cu metallisation, a TaN barrier layer can be used instead of the Ti seed layer base (Fig.2C).
D) depositing a planarising dielectric layer (25), filling the conductor holes and planarising the substrate. Preferably non-photo BCB is used for this step, due to its good hole-filling and planarising properties. One or multiple coatings could be required. A vacuum step is required to ensure proper filling of the Si holes. For BCB this is preferably performed at 170°C, as this material exhibits its largest flow at that temperature, before it starts to cure at higher temperatures. An alternative method could be the lamination of a dielectric layer, followed by a vacuum reflow step, filling the holes and planarising the substrate in a single step (Fig.2Dy).
E) plasma etching in the BCB-via fill until the conducting material (15) at the bottom (23) of the conductor hole is removed, thereby transforming the conductor hole into a dielectric hole (Fig.2Ey). The hole may be concentric to the Si-etched hole or have arbitrary shapes (multiple holes in a single Si trough-hole).
F) bottom-up electroplating a Cu-post (24), with a thickness about equal to the depth of the Si hole. In the case of a cylindrical hole, this is a Cu cylinder (Fig.2Fy).
G) stripping the top BCB layer by plasma etching (Fig.2Gy),
H) stripping the layer of conducting material (the exposed seed-layer) by wet chemical etching. During this etch the Cu via-fill will be slightly etched-back (Fig.2Hy).
I) depositing a photo-patterned dielectric layer (35), with contact openings on the Cu trough-hole fills (Fig.2Iy). A preferred dielectric for this application is photo-BCB. Patterning by dry etching of the BCB layer, exposing the Cu-fill structures. If the layer in I is photo-defined BCB, this step will not be required.
J) depositing and patterning a metal interconnect pattern (26). This could e.g. be semi-additive electroplated Cu lines. Other metals and methods are however also feasible, e.g. deposition by PVD of Cu, Al, Pt,... and patterning by wet-etching or lift-off. (Fig.2Jy)
K) depositing a second layer (27) of a second dielectric material as a passivation layer. This is preferably a BCB coating. Other materials, inorganic or organic could also be used. (Fig.2Ky)
L) Mechanical back grinding the wafers, 10 to 50 micrometer thicker than the actual Cu via post. (Fig.2Ly)
M) Plasma etching the backside of the wafer, stopping on the Cu/BCB plug and slightly over-etching the silicon. (Fig.2My)
N) Wet etching of the exposed conductive layer (seed layer) on the back-side of the thinned wafer. During this etch the Cu via-fill will be slightly etched-back. In this case, the seed layer remains present on the sidewalls of the Silicon via hole. (Fig.2Ny)
O) Solder ball (8) attachment to the Cu studs. (Fig.2Oy)

Polymer layers have a low k value and can have a relatively large thickness compared to inorganic layers. Polymers like BCB can be deposited at relatively low temperatures, when compared to for instance CVD Si oxide deposition. A typical prior art CVD Silicon oxide deposition step in order to create isolated through holes, is limited moreover by the characteristic of bad step coverage properties. Silicon oxide deposition produces layers with about uniform thickness, which limits design freedom. Silicon oxide can easily build up stress and is not flexible.

BCB is patternable, since it is for instance anisotropically dry or plasma-etchable. BCB is easy to process and spin and spray coatable. It has good planarization properties. BCB is flexible and low stress formation appears. BCB provides a large design freedom. Water absorption is low. Adhesion properties to substrate and conductor are present. Other properties of BCB can be found in Burdeaux et al., "Benzocyclobutene (BCB) Dielectrics for the Fabrication of High Density, Thin Film Multichip Modules", Journal of Electronic Materials, Vol. 19, No. 12, 1990.

The thermo-mechanical properties of polymers and silicones are such that "flexible" and less fragile structures, more specifically interconnect structures can be created. The invention allows smaller pitch and thus higher density interconnects. The method according to the present invention provides quicker, easier and cheaper processing.

## Claims

1. Method for the production of isolated through hole connects in a semiconductor substrate comprising the steps of:
A) providing a semiconductor substrate (1),
B) dry etching said substrate (1), forming at least one substrate hole (2),
C) depositing a layer of conducting material (15) on the bottom and on the sidewalls of said substrate hole (2) and optionally on top of the rest of said substrate's surface, thereby transforming said substrate hole (2) into a conductor hole,
D) depositing a positive working photo resist (22) on the top surface of the substrate and the sidewalls and bottom surface of the hole (2),
E) opening said photo resist (22) at the bottom (23) of said conductor hole,
F) bottom-up electroplating a Cu-post (24),
G) stripping said photo-resist (22),
H) stripping said layer of conducting material (15),
I) depositing a layer of planarising dielectric material (25), filling the gap between said conductor hole and said Cu-post,
J) depositing and patterning a metal interconnect pattern (26) on the layer of planarising dielectric material (25)
K) depositing a second layer (27) of a second dielectric material on the metal interconnect pattern (26),
L) Mechanical back grinding said substrate, such that said substrate is 10 to 50 micrometer thicker than the actual Cu-post,
M) Plasma etching said substrate on the backside, stopping on said Cu-post,
N) Solder ball (8) attachment to said Cu-post.

2. Method according to claim 1, wherein said positive working photo resist (22) is applied by spray-coating or electrophoretic deposition.

3. Method according to claim 1, wherein the additional step is performed of patterning by dry etching said layer of planarising dielectric material, exposing said Cu-post, before applying the step of depositing and patterning a metal interconnect pattern.

4. Method for the production of isolated through hole connects in a semiconductor substrate comprising the steps of:
A) provide a semiconductor substrate (1),
B) dry etching said substrate (1), forming at least one substrate hole (2),
C) depositing a layer of conducting material (15) on the bottom and on the sidewalls of said substrate hole (2) and optionally on top of the rest of said substrate's surface, by depositing a seed layer and performing electroplating of the conducting material, thereby transforming said substrate hole (2) into a conductor hole,
D) depositing a layer of planarising dielectric material (25), filling said conductor hole and planarising said substrate,
E) plasma etching in said layer of planarising dielectric material (25) within said conductor hole, until the conducting material (15) at the bottom (23) of said conductor hole is removed, thereby transforming said conductor hole into a dielectric hole,
F) bottom-up electroplating a Cu-post (24),
G) stripping said layer of planarising dielectric material (25),
H) stripping said layer of conducting material (15),
I) depositing a photo-patterned dielectric layer (35), with contact openings on said Cu-post (24),
J) depositing and patterning a metal interconnect pattern (26) on the photo-patterned dielectric layer (35),
K) depositing a second layer (27) of a second dielectric material on the metal interconnect pattern (26),
L) Mechanical back grinding said substrate,
M) Plasma etching said substrate on the backside, stopping on said Cu-post,
N) Etching said layer of conductive material (15) on the back-side of said substrate,
O) Solder ball (8) attachment to said Cu-post.

5. Method according to claim 4, wherein said photo-patterned dielectric layer (35) is photo benzocyclobutene (BCB).

6. Method according to claim 1 or 4, wherein said substrate (1) is a silicon wafer.

7. Method according to claim 1 or 4, wherein said substrate hole (2) is circular shaped.

8. Method according to claim 1 or 4, wherein said conducting material (15) is copper.

9. Method according to claim 1 or 4, wherein said planarising dielectric material (25) and said second dielectric material (27) is benzocyclobutene (BCB).

10. Method according to claim 1 or 4, wherein in the step of plasma etching said substrate on the backside, said substrate is over-etched with respect to said Cu-post.

## Patentansprüche

1. Verfahren zum Herstellen von isolierten Durchgangslochverbindungen in einem Halbleitersubstrat, das folgende Schritte umfasst:
A) Bereitstellen eines Halbleitersubstrats (1),
B) Trockenätzen des Substrats (1), wobei zumindest ein Substratloch (2) gebildet wird,
C) Ablagern einer Schicht aus Leitmaterial (15) auf dem Boden und auf den Seitenwänden des Substratlochs (2) und optional auf dem Rest der Oberfläche des Substrats, wodurch das Substratloch (2) in ein Leiterloch umgewandelt wird,
D) Ablagern eines positiv arbeitendes Fotolacks (22) auf die Oberseite des Substrats und die Seitenwände und die Unterseite des Lochs (2),
E) Öffnen des Fotolacks (22) am Boden (23) des Leiterlochs,
F) Bottom-up-Galvanisieren eines Cu-Stifts (24),
G) Abstreifen des Fotolacks (22),
H) Abstreifen der Schicht aus Leitmaterial (15),
I) Ablagern einer Schicht aus planarisierendem dielektrischem Material (25), die die Lücke zwischen dem Leiterloch und dem Cu-Stift füllt,
J) Ablagern und Strukturieren einer Metallzwischenverbindungsstrukturierung (26) auf der Schicht aus planarisierendem dielektrischem Material (25),
K) Ablagern einer zweiten Schicht (27) aus einem zweiten dielektrischen Material auf der Metallzwischenverbindungsstrukturierung (26),
L) Mechanisches Rückenschleifen des Substrats, so dass das Substrat 10 bis 50 Mikrometer dicker als der tatsächliche Cu-Stift ist,
M) Plasmaätzen des Substrats auf der Rückseite, wobei am Cu-Stift gestoppt wird,
N) Anbringen von Lotkugeln (8) an dem Cu-Stift.

2. Verfahren nach Anspruch 1, wobei der positiv arbeitender Fotolack (22) durch Sprühbeschichten oder elektrophoretisches Abscheiden aufgetragen wird.

3. Verfahren nach Anspruch 1, wobei der weitere Schritt des Strukturierens durch Trockenätzen der Schicht aus planarisierendem dielektrischem Material, wobei der Cu-Stift freigelegt wird, vor Anwenden des Schritts des Ablagerns und des Strukturierens einer Metallzwischenverbindungsstrukturierung durchgeführt wird.

4. Verfahren zum Herstellen von isolierten Durchgangslochverbindungen in einem Halbleitersubstrat, das folgende Schritte umfasst:
A) Bereitstellen eines Halbleitersubstrats (1),
B) Trockenätzen des Substrats (1), wobei zumindest ein Substratloch (2) gebildet wird,
C) Ablagern einer Schicht aus Leitmaterial (15) auf dem Boden und auf den Seitenwänden des Substratlochs (2) und optional auf dem Rest der Oberfläche des Substrats, durch Ablagern einer Seed-Schicht und Durchführen einer Galvanisierung des Leitmaterials, wodurch das Substratloch (2) in ein Leiterloch umgewandelt wird,
D) Ablagern einer Schicht aus planarisierendem dielektrischem Material (25), die das Leiterloch füllt und das Substrat planarisiert,
E) Plasmaätzen in der Schicht aus planarisierendem dielektrischen Material (25) innerhalb des Leiterlochs, bis das Leitmaterial (15) am Boden (23) des Leiterlochs entfernt ist, wodurch das Leiterloch in ein dielektrisches Loch umgewandelt wird,
F) Bottom-up-Galvanisieren eines Cu-Stifts (24),
G) Abstreifen der Schicht aus planarisierendem dielektrischem Material (25),
H) Abstreifen der Schicht aus Leitmaterial (15),
I) Ablagern einer photo-strukturierten dielektrischen Schicht (35), mit Kontaktöffnungen am Cu-Stift (24),
J) Ablagern und Strukturieren einer Metallzwischenverbindungsstrukturierung (26) auf der photo-strukturierten dielektrischen Schicht (35),
K) Ablagern einer zweiten Schicht (27) eines zweiten dielektrischen Materials auf der Metallzwischenverbindungsstrukturierung (26),
L) Mechanisches Rückenschleifen des Substrats,
M) Plasmaätzen des Substrats auf der Rückseite, wobei am Cu-Stift gestoppt wird,
N) Ätzen der Schicht aus Leitmaterial (15) auf der Rückseite des Substrats,
O) Anbringen von Lötkugeln (8) an dem Cu-Stift.

5. Verfahren nach Anspruch 4, wobei die photostrukturierte dielektrische Schicht (35) Photo-benzocyclobuten (BCB) ist.

6. Verfahren nach Anspruch 1 oder 4, wobei das Substrat (1) ein Siliciumwafer ist.

7. Verfahren nach Anspruch 1 oder 4, wobei das Substratloch (2) kreisförmig ausgebildet ist.

8. Verfahren nach Anspruch 1 oder 4, wobei das Leitmaterial (15) Kupfer ist.

9. Verfahren nach Anspruch 1 oder 4, wobei das planarisierende dielektrische Material (25) und das zweite dielektrische Material (27) Benzocyclobuten (BCB) ist.

10. Verfahren nach Anspruch 1 oder 4, wobei das Substrat beim Schritt des Plasmaätzens des Substrats auf der Rückseite in Bezug auf den Cu-Stift überätzt wird.

## Revendications

1. Procédé pour la production de connexions de trou de passage isolées dans un substrat semi-conducteur comprenant les étapes de :
A) fourniture d'un substrat semi-conducteur (1),
B) gravure sèche dudit substrat (1), de manière à former au moins un trou de substrat (2),
C) dépôt d'une couche de matériau conducteur (15) sur la base et sur les parois latérales dudit trou de substrat (2) et facultativement sur le reste de la surface dudit substrat, de manière à transformer ledit trou de substrat (2) en un trou de conducteur,
D) dépôt d'une résine photosensible à fonctionnement positif (22) sur la surface supérieure du substrat et la surface des parois latérales et de la base du trou (2),
E) ouverture de ladite résine photosensible (22) à la base (23) dudit trou de conducteur,
F) dépôt électrolytique de la base vers le haut d'un plot de Cu (24),
G) décapage de ladite résine photosensible (22),
H) décapage de ladite couche de matériau conducteur (15),
I) dépôt d'une couche de matériau diélectrique aplanissant (25), comblant l'espacement entre ledit trou de conducteur et ledit plot de Cu,
J) dépôt et modelage d'un motif d'interconnexion métallique (26) sur la couche de matériau diélectrique aplanissant (25)
K) dépôt d'une deuxième couche (27) d'un deuxième matériau diélectrique sur le motif d'interconnexion métallique (26),
L) meulage mécanique de la face arrière dudit substrat, de sorte que ledit substrat soit de 10 à 50 micromètres plus épais que le plot de Cu réel,
M) gravure à plasma dudit substrat sur le côté arrière, en s'arrêtant sur ledit plot de Cu,
N) fixation d'une bille de soudure (8) audit plot de Cu.

2. Procédé selon la revendication 1, dans lequel ladite résine photosensible à fonctionnement positif (22) est appliquée par enduction par pulvérisation ou dépôt életrophorétique.

3. Procédé selon la revendication 1, dans lequel l'étape supplémentaire de modelage est réalisée par gravure sèche de ladite couche de matériau diélectrique aplanissant, de manière à exposer ledit plot de Cu, avant d'appliquer l'étape de dépôt et de modelage d'un motif d'interconnexion métallique.

4. Procédé pour la production de connexions de trou de passage isolées dans un substrat semi-conducteur comprenant les étapes de :
A) fourniture d'un substrat semi-conducteur (1),
B) gravure sèche dudit substrat (1), de manière à former au moins un trou de substrat (2),
C) dépôt d'une couche de matériau conducteur (15) sur la base et sur les parois latérales dudit trou de substrat (2) et facultativement sur le reste de la surface dudit substrat, par dépôt d'une couche de germination et réalisation du dépôt électrolytique du matériau conducteur, de manière à transformer ledit trou de substrat (2) en un trou de conducteur,
D) dépôt d'une couche de matériau diélectrique aplanissant (25), de manière à remplir ledit trou de conducteur et à aplanir ledit substrat,
E) gravure à plasma dans ladite couche de matériau diélectrique aplanissant (25) dans ledit trou de conducteur, jusqu'à ce que le matériau conducteur (15) à la base (23) dudit trou de conducteur soit enlevé, transformant ainsi ledit trou de conducteur en un trou diélectrique,
F) dépôt électrolytique de la base vers le haut d'un plot de Cu (24),
G) décapage de ladite couche de matériau diélectrique aplanissant (25),
H) décapage de ladite couche de matériau conducteur (15),
I) dépôt d'une couche diélectrique photo-modelée (35), avec des ouvertures de contact sur ledit plot de Cu (24),
J) dépôt et modelage d'un motif d'interconnexion métallique (26) sur la couche diélectrique photo-modelée (35),
K) dépôt d'une deuxième couche (27) d'un deuxième matériau diélectrique sur le motif d'interconnexion métallique (26),
L) meulage mécanique de la face arrière dudit substrat,
M) gravure à plasma dudit substrat sur le côté arrière, en s'arrêtant sur ledit plot de Cu,
N) gravure de ladite couche de matériau conducteur (15) sur le côté arrière dudit substrat,
O) fixation d'une bille de soudure (8) audit plot de Cu.

5. Procédé selon la revendication 4, dans lequel ladite couche diélectrique photo-modelée (35) est du photo-benzocyclobutène (BCB).

6. Procédé selon la revendication 1 ou 4, dans lequel ledit substrat (1) est une tranche de silicium.

7. Procédé selon la revendication 1 ou 4, dans lequel ledit trou de substrat (2) est de forme circulaire.

8. Procédé selon la revendication 1 ou 4, dans lequel ledit matériau conducteur (15) est du cuivre.

9. Procédé selon la revendication 1 ou 4, dans lequel ledit matériau diélectrique aplanissant (25) et ledit deuxième matériau diélectrique (27) est le benzocyclobutène (BCB).

10. Procédé selon la revendication 1 ou 4, dans lequel, dans l'étape de gravure à plasma dudit substrat sur le côté arrière, ledit substrat est surgravé par rapport audit plot de Cu.
